# EUROPEAN PATENT SPECIFICATION

(11) **EP 2 966 690 B1**
(45) Date of publication and mention of the grant of the patent: **26.02.2020**
(21) Application number: 15181700.4
(22) Date of filing: 26.03.2009
(51) Int. Cl.: H01L 29/78, H01L 21/336, H01L 29/12, H01L 29/06

(54) **SEMICONDUCTOR DEVICE AND METHOD FOR MANUFACTURING THE SAME**
HALBLEITERBAUELEMENT UND VERFAHREN ZUR HERSTELLUNG DAVON
DISPOSITIF SEMICONDUCTEUR ET SON PROCÉDÉ DE FABRICATION

(30) Priority: 26.03.2008 JP 2008080216; 26.12.2008 JP 2008333530
(43) Date of publication of application: 13.01.2016
(62) Divisional of application: 09724334.9
(73) Proprietor: ROHM CO., LTD., Kyoto-shi, Kyoto 615-8585 (JP)
(72) Inventor: Nakano, Yuki, Kyoto-shi, Kyoto 615-8585 (JP)
(74) Representative: Boult Wade Tennant LLP

(56) References cited:
- EP-A2- 0 889 511
- EP-A2- 1 359 624
- WO-A1-97/47045
- US-A1- 2006 267 090
- US-A1- 2007 013 000
- US-A1- 2007 093 019
- US-A1- 2007 194 375
- NARAZAKI A ET AL: "A marvelous low on-resistance 20V rated self alignment trench MOSFET (SAT-MOS) in a 0.35/spl mu/m LSI design rule with both high forward blocking voltage yield and large current capability", POWER SEMICONDUCTOR DEVICES AND ICS, 2004. PROCEEDINGS. ISPSD '04. THE 16TH INTERNATIONAL SYMPOSIUM ON KITAKYUSHU INT. CONF. CTR, JAPAN MAY 24-27, 2004, PISCATAWAY, NJ, USA,IEEE, 24 May 2004 (2004-05-24), pages 393-396, XP010723429, ISBN: 978-4-88686-060-6

## Description

### TECHNICAL FIELD

The present invention relates to a semiconductor device having a trench structure, and also to a method of manufacturing such a semiconductor device.

### BACKGROUND ART

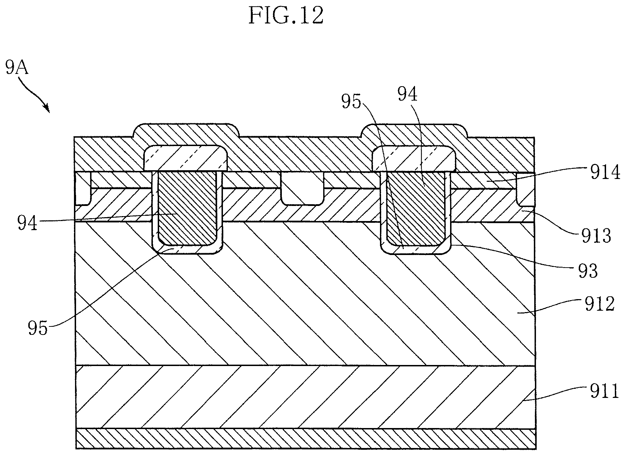

Fig. 12 illustrates an example of a cross-section of a conventional vertically stacked insulated-gate semiconductor device that includes a trench structure. The semiconductor device 9A includes a first n-type semiconductor layer 911, a second n-type semiconductor layer 912, a p-type semiconductor layer 913, an n-type semiconductor region 914, a trench 93, a gate electrode 94 and a gate insulating layer 95.

The first n-type semiconductor layer 911 serves as the base of the semiconductor device 9A. The second n-type semiconductor layer 912 is provided on the first n-type semiconductor layer 911. The p-type semiconductor layer 913 is provided on the second n-type semiconductor layer 912. The n-type semiconductor region 914 is provided on the p-type semiconductor layer 913.

The trench 93 is formed so as to penetrate through the n-type semiconductor region 914 and the p-type semiconductor layer 913, and to reach the second n-type semiconductor layer 912. Inside the trench 93, the gate electrode 94 and the gate insulating layer 95 are located. The gate insulating layer 95 serves to insulate the gate electrode 94 from the second n-type semiconductor layer 912, the p-type semiconductor layer 913, and the n-type semiconductor region 914. The gate insulating layer 95 is formed along the inner wall of the trench 93.

In the semiconductor device 9A thus configured, when a reverse bias is applied, field concentration takes place on the bottom portion of the gate insulating layer 95. The field concentration may provoke dielectric breakdown of the gate insulating layer 95.

Further examples are disclosed in WO 97/47045, US 2007/194375, US 2006/267090, EP-A2-1,359,624, US 2007/013000, and EP-A2-0,889,511.

In WO 97/47045 there is described a silicon carbide metal-insulator semiconductor field effect transistor having a u-shaped gate trench and an n-type silicon carbide drift layer. A p-type region is formed in the silicon carbide drift layer and extends below the bottom of the u-shaped gate trench so as to prevent field crowding at the corner of the gate trench. A unit cell of a metal-insulator semiconductor transistor is provided having a bulk single crystal silicon carbide substrate of n-type conductivity silicon carbide, a first epitaxial layer of n-type conductivity silicon carbide and a second epitaxial layer of p-type conductivity silicon carbide formed on the first epitaxial layer. A first trench is formed which extends downward through the second epitaxial layer and into the first epitaxial layer. A second trench, adjacent the first trench, is also formed extending downward through the second epitaxial layer and into the first epitaxial layer. A region of n-type conductivity silicon carbide is formed between the first and second trenches and having an upper surface opposite the second epitaxial layer. An insulator layer is formed in the first trench where the upper surface of the gate insulator layer formed on the bottom of the first trench is below the lower surface of the second epitaxial layer. A region of p-type conductivity silicon carbide is formed in the first epitaxial layer below the second trench. Gate and source contacts are formed in the first and second trenches respectively and a drain contact is formed on the substrate. Preferably the gate insulator layer is an oxide such that the transistor formed is a metal-oxide field effect transistor.

In US 2007/0194375 there is described a semiconductor device comprising a first semiconductor layer of a first conductivity type, an epitaxial layer of a first conductivity type formed in the surface on the first semiconductor layer, and a base layer of a second conductivity type formed on the surface of the epitaxial layer. Column layers of a second conductivity type are repeatedly formed in the epitaxial layer under the base layer at a certain interval. Trenches are formed so as to penetrate the base layer to reach the epitaxial layer; and gate electrodes are formed in the trenches via a gate insulation film. A termination layer of a second conductivity type is formed on the epitaxial layer at an end region at the perimeter of the base layer. The termination layer is formed to have a junction depth larger than that of the base layer.

In US 2006/0267090 there is described a monolithically integrated field effect transistor and Schottky diode which includes gate trenches extending into a semiconductor region. Source regions having a substantially triangular shape flank each side of the gate trenches. A contact opening extends into the semiconductor region between adjacent gate trenches. A conductor layer fills the contact opening to electrically contact the source regions along at least a portion of a slanted sidewall of each source region, and the semiconductor region along a bottom portion of the contact opening, wherein the conductor layer forms a Schottky contact with the semiconductor region.

In EP-A2-1, 359, 624 there is described a vertical type MOSFET, in which an n-type high resistance drift layer is formed on an n-type substrate and p-type base layers are formed in designated regions of the surface of the high resistance drift layer and n-type source layers are formed in the base layers and gate electrodes are formed on specified regions of the surface of the high resistance drift layer. A trench type back gate section is formed in a trench positioned at a region between the gate electrodes by filling an insulation material in the trench. Also, p-type impurity layers are formed in the high resistance drift layer at the region directly under the trench type back gate section. The p-type impurity layers are formed by implanting ions from the bottom of the trench, after the trench is formed. After this, the trench is filled with an insulation material. With this, by securing the breakdown voltage of about 150V (middle class) by the provision of the impurity layers, the concentration of the impurity in the high resistance drift layer is made to be higher, the drift resistance is lowered.

In US 2007/013000 there is described a device structure which allows formation of a fine SJ structure in a low withstand voltage power MOSFET. A manufacturing method is also described. An n-type epitaxial layer which is a current path and a trench structure which extends from a semiconductor surface into the n-type epitaxial layer are provided. A floating p-type region is formed in a portion of the n-type epitaxial layer positioned below the trench structure . The p-type region is formed below the trench structure by ion-implanting p-type impurity ions. By forming the p-type region below a fine trench gate through ion-implantation, energy for ion-implantation can be reduced, and a fine SJ structure can be fabricated.

In EP-A2-0,889,511 there is described a trench process for establishing a contact for a semiconductor device with trenches such as the trench and planar MOSFETs (UMOS), trench and planar IGBTs and trench MCTs which reduces the number of masks and eliminates the need for lateral diffusion into the trench channel region. Control of the parasitic transistor in the trench MOSFET is also achieved. The cell size/pitch is reduced relative to conventional processes which require source block and p+ masks.

The present invention has been conceived with the object of providing a semiconductor device that can suppress the dielectric breakdown in the insulating layer, and a method of manufacturing such semiconductor device.

### SUMMARY OF THE INVENTION

A first aspect of the present invention provides a semiconductor device comprising the features of claim 1.

A second aspect of the present invention provides a method of manufacturing a semiconductor device, comprising the steps of claim 10.

Other features and advantages of the present invention will become more apparent through detailed description given below referring to the accompanying drawings.

### BRIEF DESCRIPTION OF THE DRAWINGS

Fig. 1 is a fragmentary cross-sectional view of a semiconductor device;
Fig. 2 is a fragmentary cross-sectional view for explaining a manufacturing process of the semiconductor device shown in Fig. 1;
Fig. 3 is a fragmentary cross-sectional view for explaining a manufacturing process following the state shown in Fig. 2;
Fig. 4 is a fragmentary cross-sectional view of a semiconductor device according to an embodiment of the present invention;
Fig. 5A is a fragmentary cross-sectional view for explaining a manufacturing process of the semiconductor device shown in Fig. 4;
Fig. 5B is a fragmentary cross-sectional view for explaining a manufacturing process following the state shown in Fig. 5A;
Fig. 6 is a fragmentary cross-sectional view of a semiconductor device according to another embodiment of the present invention;
Fig. 7 is a fragmentary cross-sectional view of a semiconductor device according to a further example;
Fig. 8A is a fragmentary cross-sectional view for explaining a manufacturing process following the state shown in Fig. 7;
Fig. 8B is a fragmentary cross-sectional view for explaining a manufacturing process following the state shown in Fig. 8A;
Fig. 9A is a fragmentary cross-sectional view for explaining a manufacturing process following the state shown in Fig. 8B;
Fig. 9B is a fragmentary cross-sectional view for explaining a manufacturing process following the state shown in Fig. 9A;
Fig. 10 is a fragmentary cross-sectional view for explaining a manufacturing process following the state shown in Fig. 9B;
Fig. 11 is a fragmentary cross-sectional view of a semiconductor device according to yet a further example; and
Fig. 12 is a fragmentary cross-sectional view of a conventional semiconductor device.

### BEST MODE FOR CARRYING OUT THE INVENTION

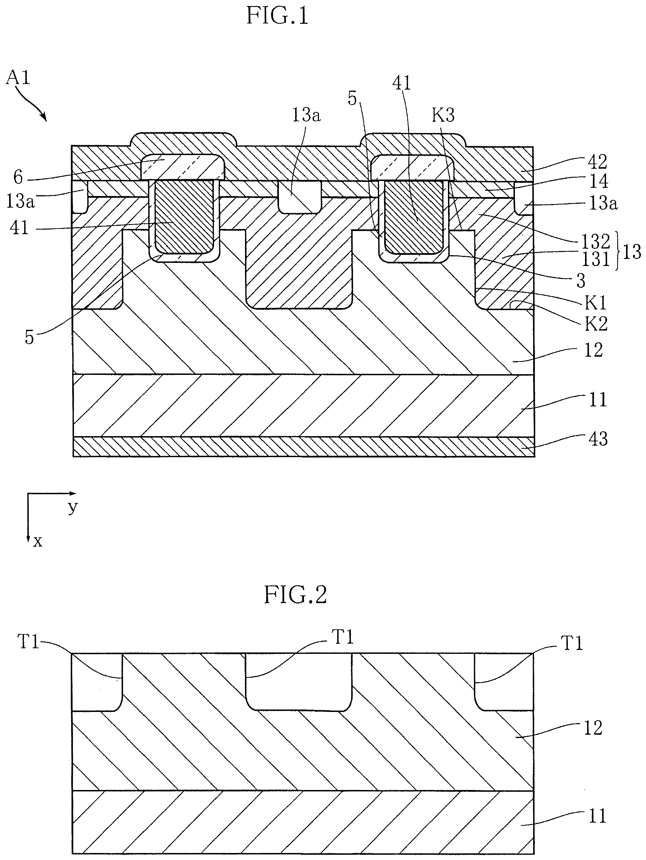

Fig. 1 illustrates a semiconductor device. The semiconductor device A1 includes a first n-type semiconductor layer 11, a second n-type semiconductor layer 12, a p-type semiconductor layer 13, an n-type semiconductor region 14, a high-concentration p-type semiconductor region 13a, a trench 3, a gate electrode 41, a gate insulating layer 5, a source electrode 42, a drain electrode 43 and an interlayer dielectric 6.

The first n-type semiconductor layer 11 is a substrate constituted of silicon carbide with a high-concentration impurity added thereto. The second n-type semiconductor layer 12 is provided on the first n-type semiconductor layer 11. The second n-type semiconductor layer 12 is constituted of silicon carbide with a low-concentration impurity added thereto.

The p-type semiconductor layer 13 includes a first p-type semiconductor layer 131 and a second p-type semiconductor layer 132. The first p-type semiconductor layer 131 is provided on the second n-type semiconductor layer 12. Of the boundary between the first p-type semiconductor layer 131 and the second n-type semiconductor layer 12, a portion along a depthwise direction x of the trench 3 will be referred to as a lateral boundary K1, and a portion along a widthwise direction y will be referred to as a bottom boundary K2. In this example, the bottom boundary K2 is spaced from the boundary between the n-type semiconductor region 14 and the source electrode 42, by approximately 1 µm. The impurity concentration of the first p-type semiconductor layer 131 is, for example, 1×10¹⁷cm⁻³ to 1×10²⁰cm⁻³. The second p-type semiconductor layer 132 is provided on the first p-type semiconductor layer 131 and the second n-type semiconductor layer 12. Of the boundary between the second p-type semiconductor layer 132 and the second n-type semiconductor layer 12, a portion along the widthwise direction y will be referred to as a bottom boundary K3. The impurity concentration of the second p-type semiconductor layer 132 is, for example, 1×10¹⁶cm⁻³ to 1×10¹⁹cm⁻³. The n-type semiconductor region 14 is provided on the p-type semiconductor layer 13. The high-concentration p-type semiconductor region 13a is provided on the first p-type semiconductor layer 131.

The trench 3 is formed so as to penetrate through the n-type semiconductor region 14 and the second p-type semiconductor layer 132, and to reach the second n-type semiconductor layer 12. The trench 3 and the first p-type semiconductor layer 131 are spaced from each other by approximately 0.3 µm, when viewed in the widthwise direction y.

Inside the trench 3, the gate electrode 41 and the gate insulating layer 5 are located. The gate electrode 41 is constituted of, for example, polysilicon. Alternatively, a metal such as aluminum may be employed to form the gate electrode 41. The gate insulating layer 5 is constituted of silicon dioxide for example, and serves to insulate the gate electrode 41 from the second n-type semiconductor layer 12, the p-type semiconductor layer 13, and the n-type semiconductor region 14. The gate insulating layer 5 is provided along the inner wall of the trench 3 and over the bottom portion and the lateral portion of the trench 3.

In the depthwise direction x, the bottom boundary K3, the bottom portion of the gate electrode 41, the bottom portion of the trench 3, and the bottom boundary K2 are located in the mentioned order, downwardly in Fig. 1.

The source electrode 42 is for example constituted of aluminum, and located in contact with the n-type semiconductor region 14 and the high-concentration p-type semiconductor region 13a. The drain electrode 43 is also constituted of aluminum for example, and located in contact with the first n-type semiconductor layer 11. The drain electrode 43 is provided on the opposite side of the first n-type semiconductor layer 11 to the second n-type semiconductor layer 12. The interlayer dielectric 6 is formed so as to cover the gate electrode 41.

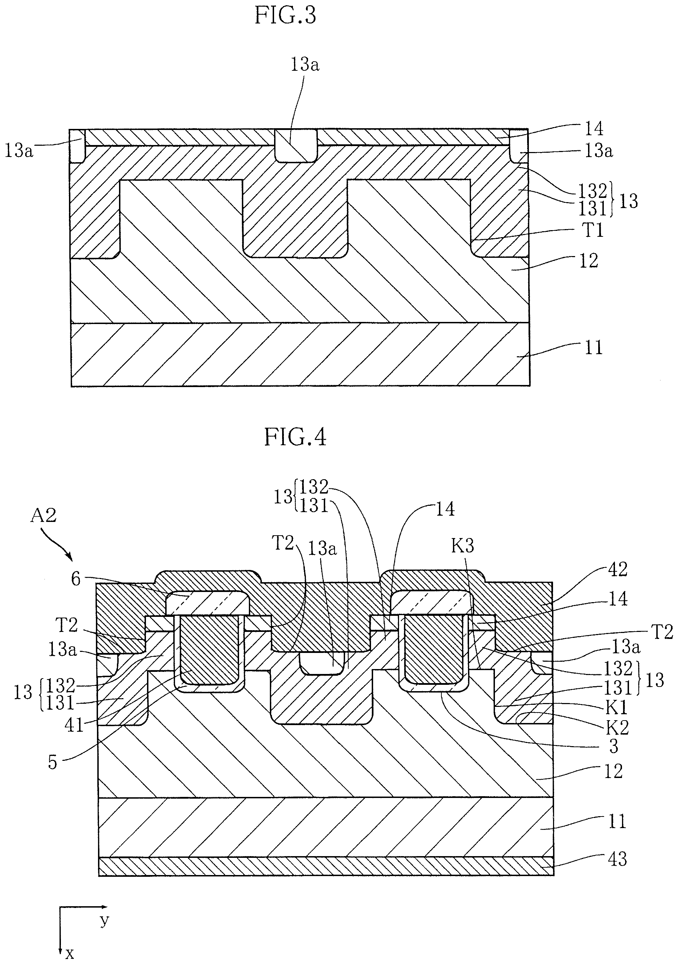

Now, an example of the manufacturing method of the semiconductor device A1 will be described, referring to Figs. 2 and 3.

Referring first to Fig. 2, a semiconductor substrate which is to serve as the first n-type semiconductor layer 11 is prepared. On the upper surface of the substrate, the second n-type semiconductor layer 12 is formed through epitaxial crystal growth. Then a groove T1 is formed on the surface of the second n-type semiconductor layer 12.

Referring then to Fig. 3, the first p-type semiconductor layer 131 is formed inside the groove T1 through the epitaxial crystal growth. The surface of the substrate is then planarized. On the planarized substrate, the second p-type semiconductor layer 132 is formed through the epitaxial crystal growth.

Then a mask of a predetermined pattern is placed over the upper surface of the second p-type semiconductor layer 132, and impurity ions (n-type or p-type) are injected. Thus the n-type semiconductor region 14 and the high-concentration p-type semiconductor region 13a are formed.

The above is followed by the formation of the trench 3, the gate insulating layer 5 and the gate electrode 41 shown in Fig. 1. Then the interlayer dielectric 6, the source electrode 42, and the drain electrode 43 are formed. Through the foregoing process, the semiconductor device A1 can be obtained.

The advantageous effects of the semiconductor device A1 will now be described hereunder. In this example, the bottom boundary K2 is at a lower level than the bottom portion of the trench 3, according to the orientation of Fig. 1. Such configuration encourages the field concentration on the boundary between the first p-type semiconductor layer 131 and the second n-type semiconductor layer 12. Accordingly, the field concentration on the bottom portion of the trench 3 is mitigated. Mitigating the field concentration reduces the risk of dielectric breakdown in the gate insulating layer 5. As a result, the withstand voltage of the semiconductor device A1 can be improved.

The structure according to this example allows reducing the impurity concentration of the second p-type semiconductor layer 132. This facilitates lowering the threshold voltage of the semiconductor device A1. On the other hand, increasing the impurity concentration of the first p-type semiconductor layer 131 allows suppressing extension of a depletion layer in the first p-type semiconductor layer 131, thereby preventing a punch through phenomenon.

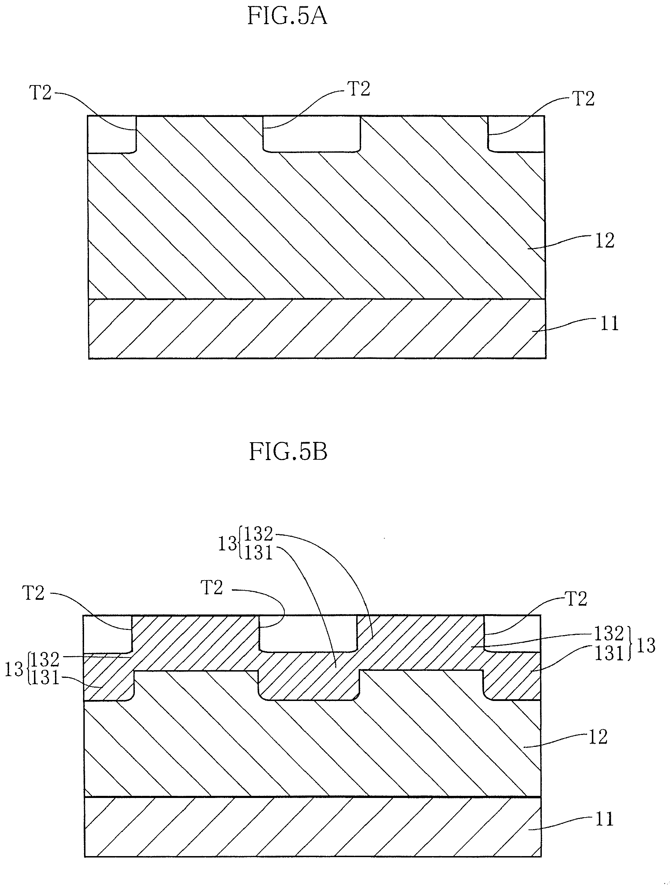

Figs. 4, 5A and 5B illustrate an embodiment of the present invention. In these drawings, the constituents which are the same as or similar to those of the foregoing example are given the same numeral. The semiconductor device A2 according to this embodiment is different from the semiconductor device A1 according to the first example in including a recessed portion T2.

In the semiconductor device A2 shown in Fig. 4, the impurity concentration in the first p-type semiconductor layer 131 is the same as that in the second p-type semiconductor layer 132, as in the first example.

Above the first p-type semiconductor layer 131 according to the orientation of Fig. 4, a recessed portion T2 is provided. In this embodiment, the size of the opening of the recessed portion T2 in the widthwise direction y is slightly smaller than that of the first p-type semiconductor layer 131 in the widthwise direction y. The bottom portion of the recessed portion T2 is located higher than the bottom boundary K2, according to Fig. 4. Also, the bottom portion of the recessed portion T2 is located higher than the bottom boundary K3 in Fig. 4. The high-concentration p-type semiconductor region 13a is located below the recessed portion T2. It is not mandatory that the bottom portion of the recessed portion T2 is located higher than the bottom boundary K3. For example, the bottom portion of the recessed portion T2 may be located lower than the bottom portion of the trench 3. The position of the bottom portion of the recessed portion T2 may be determined irrespective of the position of the bottom boundary K3 and the bottom portion of the trench 3.

Referring now to Figs. 5A and 5B, an example of the manufacturing method of the semiconductor device A2 will be described hereunder.

First, as shown in Fig. 5A, a semiconductor substrate which is to serve as the first n-type semiconductor layer 11 is prepared. On the upper surface of the substrate, the second n-type semiconductor layer 12 is formed through the epitaxial crystal growth. Then the recessed portion T2 is formed on the surface of the second n-type semiconductor layer 12, in a depth of approximately 0.5 µm.

Referring then to Fig. 5B, the first p-type semiconductor layer 131 is formed. To form the first p-type semiconductor layer 131, a mask (not shown) is placed over the upper surface of the substrate, and the recessed portion T2 is irradiated with impurity ions (p-type) from above in Fig. 5B, with energy of approximately 400 KeV. Then the region on the surface of the second n-type semiconductor layer 12 where the recessed portion T2 is not formed is irradiated with impurity ions (p-type), with generally the same energy. As a result, the second p-type semiconductor layer 132 is formed. Here, the ion concentration in the first p-type semiconductor layer 131 and the second p-type semiconductor layer 132 can be controlled by adjusting the duration of the ion irradiation.

Alternatively, according to the present invention the entire surface of the second n-type semiconductor layer 12 may be irradiated with impurity ions from above in Fig. 5B, without putting the mask on the upper surface of the substrate. By such impurity ion irradiation, the first p-type semiconductor layer 131 and the second p-type semiconductor layer 132 can be formed in different depths from the surface of the second n-type semiconductor layer 12. This process is especially useful in the case where it is not necessary to control the impurity concentration in the first p-type semiconductor layer 131 and the second p-type semiconductor layer 132.

The above is followed by the formation of the n-type semiconductor region 14 and the high-concentration p-type semiconductor region 13a shown in Fig. 4. These regions can also be formed by injecting impurity ions (n-type or p-type) to the second n-type semiconductor layer 12. Then the trench 3 is formed in the region where the second p-type semiconductor layer 132 has been formed. Inside the trench 3, the gate insulating layer 5 and the gate electrode 41 are formed. Then the interlayer dielectric 6, the source electrode 42, and the drain electrode 43 are formed. Through the foregoing process, the semiconductor device A2 can be obtained.

According to this embodiment, providing the recessed portion T2 allows forming a deeper portion of the first p-type semiconductor layer 131 by the ion irradiation with lower energy.

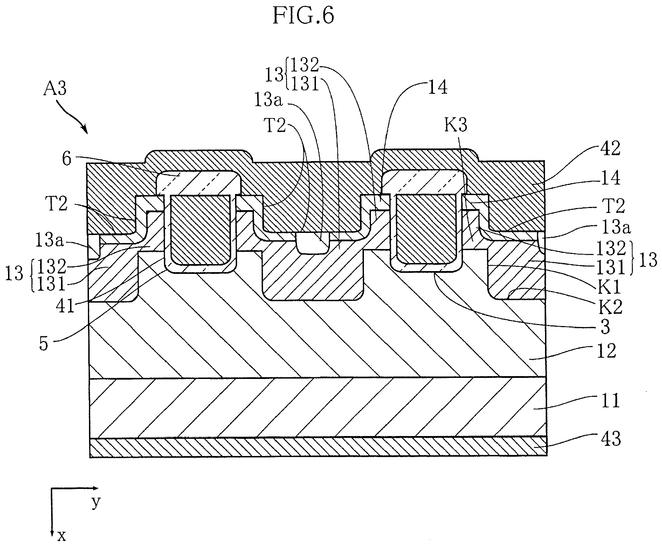

Fig. 6 illustrates another embodiment of the present invention. As in the preceding drawings, the constituents in Fig. 6 which are the same as or similar to those of the foregoing semiconductor devices are given the same numeral. The semiconductor device A3 according to this embodiment is different from the semiconductor device A2 according to the previous embodiment in that the n-type semiconductor region 14 is also provided under the recessed portion T2. Such configuration increases the contact area between the source electrode 42 and the n-type semiconductor region 14. Accordingly, the contact resistance between the source electrode 42 and the n-type semiconductor region 14 can be reduced, in the semiconductor device A3.

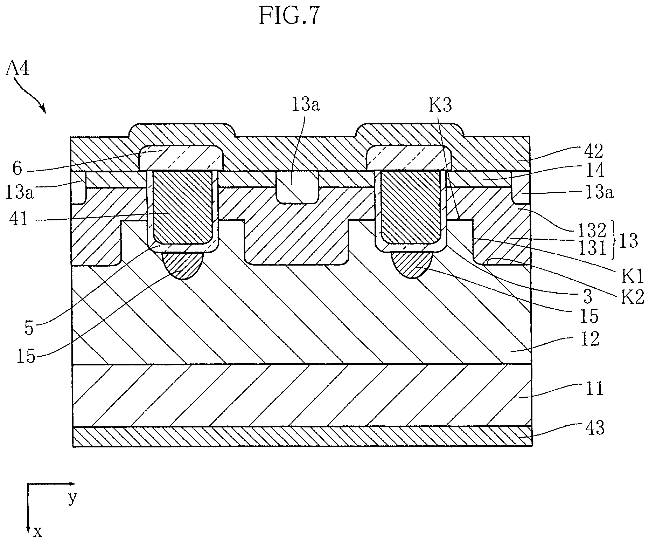

Figs. 7 to 10 illustrate a further example of a semiconductor device. In these drawings, the constituents which are the same as or similar to those of the foregoing devices are given the same numeral. The semiconductor device A4 according to this example is different from the semiconductor device A1 according to the first example in including a p-type semiconductor region 15.

As is apparent in Fig. 7, the p-type semiconductor region 15 is located in contact with the bottom portion of the trench 3. The impurity concentration in the p-type semiconductor region 15 is, for example, 1×10¹⁶cm⁻³ to 1×10²¹cm⁻³ . The size of the boundary between the p-type semiconductor region 15 and the bottom portion of the trench 3 in the widthwise direction y is slightly smaller than that of the gate electrode 41 in the widthwise direction y. Also, a lowermost portion of the p-type semiconductor region 15 according to the orientation of Fig. 7 is located lower than the bottom boundary K2 in the depthwise direction x. Conversely, although not shown, the bottom boundary K2 may be located lower than the lowermost portion of the p-type semiconductor region 15.

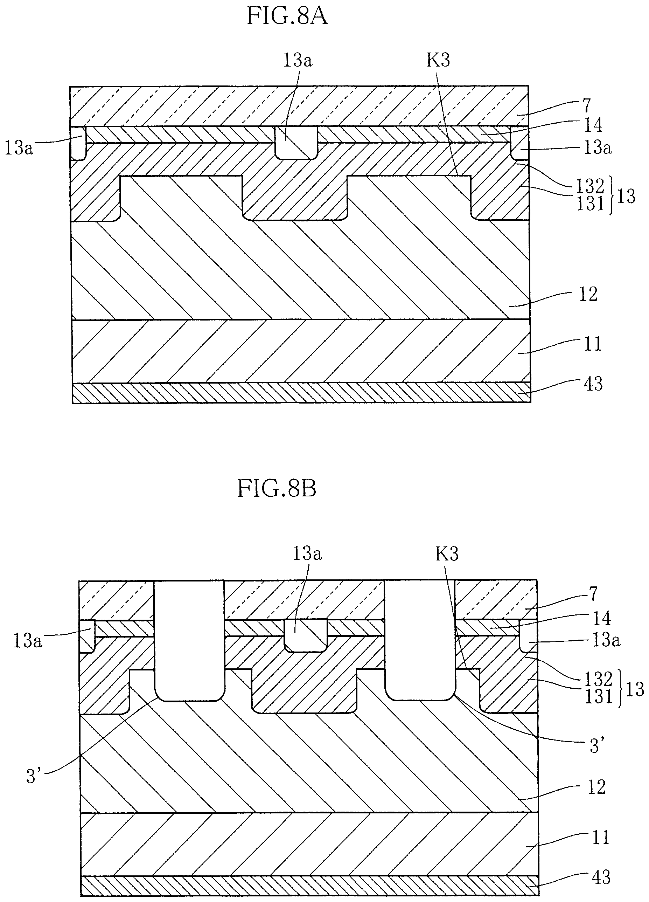

Referring now to Figs. 8 to 10, an example of the manufacturing method of the semiconductor device A4 will be described hereunder.

The manufacturing method of the semiconductor device A4 is the same as that of the semiconductor device A1 according to the first example, up to the state shown in Fig. 3. Accordingly, the description of the process up to Fig. 3 is not repeated. Referring thus to Fig. 8A, a plasma CVD is performed over the upper surface of the structure shown in Fig. 3, to thereby form a silicon dioxide layer 7. The silicon dioxide layer 7 serves as the mask for forming the trench 3 and the p-type semiconductor region 15, as will be subsequently described. Proceeding to Fig. 8B, a trench 3' is formed so as to penetrate through all of the silicon dioxide layer 7, the n-type semiconductor region 14, and the p-type semiconductor layer 13. The trench 3' is to be formed into the trench 3 shown in Fig. 7. Then the inner wall of the trench 3' is thermally oxidized (not shown).

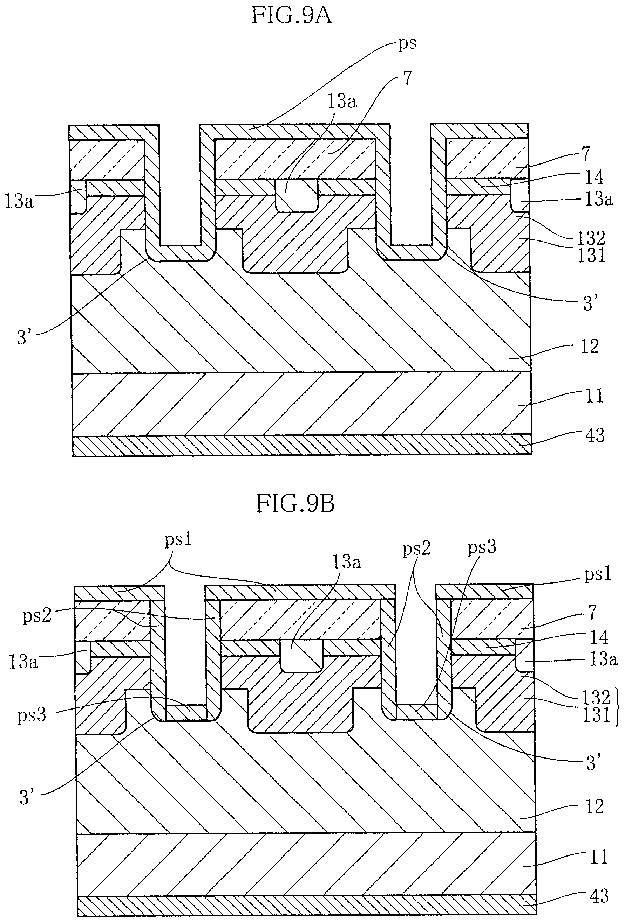

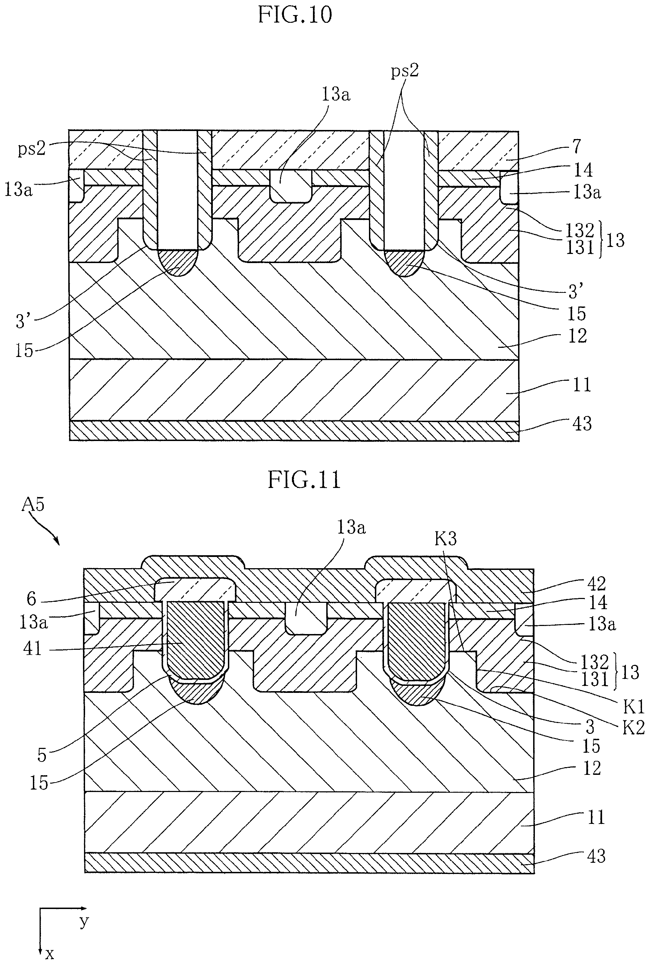

Then as shown in Fig. 9A, a polysilicon layer ps is formed all over the inner wall of the trench 3' and the upper surface of the silicon dioxide layer 7. Then as shown in Figs. 9B and 10, a polysilicon layer ps1 and a polysilicon layer ps3 are removed, leaving a polysilicon layer ps2 unremoved. Impurity ions (p-type) are then injected to the bottom portion of the trench 3', as shown in Fig. 10. At this stage, the p-type semiconductor region 15 is formed. Then the entirety of the silicon dioxide layer 7 and the polysilicon layer ps2 are removed. This is followed by the same process as that described in the first example. Thus, the semiconductor device A4 shown in Fig. 7 can be obtained.

The advantageous effects of the semiconductor device A4 will now be described hereunder.

The structure of the semiconductor device A4 allows further mitigating the field concentration on the bottom portion of the trench 3. Accordingly, the withstand voltage of the semiconductor device A4 can be further improved. Here, reducing the size of the p-type semiconductor region 15 in the widthwise direction y allows suppressing an increase in on-resistance.

Fig. 11 illustrates yet a further example of a semiconductor device. In Fig. 11, the constituents which are the same as or similar to those of the foregoing devices are given the same numeral. A difference between the semiconductor device A5 according to this example and the semiconductor device A4 according to the previous example lies in the shape of the trench 3.

As shown in Fig. 11, the additional p-type semiconductor layer 15 is provided so as to cover the bottom portion of the trench 3. Such configuration allows further increasing the withstand voltage. Also, the bottom portion of the trench 3 is formed in a trapezoidal shape. As a result, the additional p-type semiconductor layer 15 can be formed within an area overlapping with the trench 3 in the widthwise direction y. The foregoing structure prevents the flow of electron in the semiconductor device A5 from being disturbed, thereby suppressing an increase in on-resistance. Consequently, the dielectric breakdown electric field can be further increased, while an increase in on-resistance can be suppressed.

The semiconductor device and the manufacturing method of the same according to the present invention are not limited to the foregoing embodiments. Specific structure and arrangement of the semiconductor device and the manufacturing method according to the present invention may be varied in different manners.

## Claims

1. A semiconductor device comprising:
a semiconductor layer (11, 12, 13) having a first face provided with a trench (3) and a second face opposite to the first face;
a gate electrode (41) provided in the trench (3);
a source electrode (42) provided on the first face of the semiconductor layer (11,12,13); and
an insulating layer (5) provided in the trench (3) so as to insulate the semiconductor layer (11,12,13) and the gate electrode (41) from each other;
wherein the semiconductor layer (11,12,13) includes a first semiconductor layer (11,12) of a first conductivity type constituted of silicon carbide, and a second semiconductor implanted layer (13) of a second conductivity type opposite to the first conductivity type,
the trench (3) being formed so as to penetrate through the second semiconductor layer (13) and to reach the first semiconductor layer (11,12),
wherein the second semiconductor layer (13) includes a close portion (131) which is closer to the second face of the semiconductor layer (11, 12, 13) than is the trench (3), the trench (3) and the close portion (131) being spaced from each other when viewed in a widthwise direction (y) perpendicular to a depthwise direction (x) of the trench (3),
wherein the semiconductor layer (11, 12, 13) further includes a semiconductor region (14) of the first conductivity type formed around and in direct contact with the trench (3),
wherein a recessed portion (T2) is provided at the second semiconductor layer (13),
the second semiconductor layer (13) comprises a first region (131) and a second region (132), the first region (131) being located below the recessed portion (T2) and including the close portion (131), the second region (132) being connected with the first region (131) in the widthwise direction (y), the first region (131) having a first bottom boundary (K2) in contact with the first semiconductor layer (11, 12), the second region (132) having a second bottom boundary (K3) in contact with the first semiconductor layer (11, 12),
the first region (131) and the second region (132) comprising the same dopant impurity and having the same dopant impurity concentration,
the close portion (131) and the recessed portion (T2) being disposed so as to overlap in the widthwise direction (y),
the recessed portion (T2) being smaller in size than the close portion (131) in the widthwise direction (y), and
including a bottom surface facing the close portion (131), the bottom surface being spaced apart from a top surface of the first semiconductor layer (11,12) toward the first face of the semiconductor layer (11,12,13,14),
wherein a part of the source electrode (42) is disposed in the recessed portion (T2) and
wherein the semiconductor layer (11, 12, 13) further includes a high-concentration semiconductor region (13a) of the second conductivity type under the recessed portion (T2),
wherein a size of the recessed portion (T2) in the depthwise direction (x) is substantially equal to a distance between the first bottom boundary (K2) and the second bottom boundary (K3) in the depthwise direction (x).

2. The semiconductor device according to claim 1, wherein the second region (132) includes a channel region formed along the trench (3) and in contact with the first semiconductor layer (11, 12).

3. The semiconductor device according to claim 1 or 2, wherein the recessed portion (T2) includes a side surface connected to the bottom surface, and an impurity concentration at the bottom surface is greater than an impurity concentration at the side surface.

4. The semiconductor device according to any one of claims 1-3, wherein the semiconductor region (14) extends onto the bottom surface of the recessed portion (T2).

5. The semiconductor device according to claim 3, wherein the side surface of the recessed portion (T2) is substantially parallel to depthwise direction (x).

6. The semiconductor device according to any one of claims 1-5, wherein the high-concentration semiconductor region (13a) is disposed between the close portion (131) and the recessed portion (T2) in the widthwise direction (y), and held in direct contact with said part of the source electrode (42) disposed in the recessed portion (T2).

7. The semiconductor device according to claim 6, wherein the high-concentration semiconductor region (13a) is smaller in size than the bottom surface of the recessed portion (T2) in the widthwise direction (y).

8. A method of manufacturing a semiconductor device, the method comprising:
forming a recessed portion (T2) on a surface of a semiconductor substrate (11,12) constituted of silicon carbide;
irradiating the entire surface of the semiconductor substrate (11,12) with ions thereby forming a first semiconductor region (131) and a second semiconductor region (132) of a conductivity type different from a conductivity type of the semiconductor substrate (11, 12), the first and the second semiconductor regions (131, 132) being connected with each other,
the first semiconductor region (131) being located close to a bottom portion of the recessed portion (T2), the first semiconductor region (131) having a first bottom boundary (K2) in contact with the semiconductor substrate (11, 12), the second semiconductor region (132) having a second bottom boundary (K3) in contact with the semiconductor substrate (11, 12);
forming a trench (3) in the region where the second semiconductor region (132) has been formed, the trench (3) penetrating through the second semiconductor region (132);
forming an insulating layer (5) in the trench (3);
forming a gate electrode (41) stacked on the insulating layer (5) in the trench (3); and
forming a source electrode (42) on the semiconductor substrate (11,12) in a manner such that a part of the source electrode (42) is disposed in the recessed portion (T2),
wherein the recessed portion (T2) is smaller in size than the first semiconductor region (131) in a widthwise direction (y) perpendicular to a depthwise direction (x) of the trench (3),
the method further comprising forming a high-concentration semiconductor region (13a) in the first semiconductor region (131), wherein the high-concentration semiconductor region is of a conductivity type different from the conductivity type of the semiconductor substrate (11,12) and held in direct contact with the bottom portion of the recessed portion (T2), the high-concentration semiconductor region (13a) being spaced apart from the semiconductor substrate (11,12), the recessed portion (T2) being greater in size measured in the widthwise direction (y) than the high-concentration semiconductor region (13a),
wherein a size of the recessed portion (T2) in the depthwise direction (x) is substantially equal to a distance between the first bottom boundary (K2) and the second bottom boundary (K3) in the depthwise direction (x).

9. The method according to claim 8, further comprising forming a third semiconductor region (14) on the second semiconductor region (132), the third semiconductor region (14) having the same conductivity type as that of the semiconductor substrate (11, 12).

10. The method according to any one of claims 8 or 9, wherein the step of forming the gate electrode (41) is performed after the first semiconductor region (131) and the second semiconductor region (132) are formed.

## Patentansprüche

1. Halbleiterbauteil mit:
einer Halbleiterschicht (11, 12, 13), die eine erste Stirnfläche aufweist, die mit einem Graben (3) versehen ist, und eine zweite Stirnfläche aufweist, die der ersten Stirnfläche gegenüber liegt;
einer Gate-Elektrode (41), die in dem Graben (3) vorgesehen ist;
einer Source-Elektrode (42), die auf der ersten Stirnfläche der Halbleiterschicht (11, 12, 13) vorgesehen ist; und
einer isolierenden Schicht (5), die in dem Graben (3) vorgesehen ist, um die Halbleiterschicht (11, 12, 13) und die Gate-Elektrode (41) voneinander zu isolieren;
wobei die Halbleiterschicht (11, 12, 13) eine erste Halbleiterschicht (11, 12) eines ersten Leitfähigkeitstyps beinhaltet, die aus Siliziumkarbid aufgebaut ist, und eine zweite implantierte Halbleiterschicht (13) eines zweiten Leitfähigkeitstyps aufweist, der entgegengesetzt ist zu dem ersten Leitfähigkeitstyp,
wobei der Graben (3) so ausgebildet ist, dass er die zweite Halbleiterschicht (13) durchdringt und die erste Halbleiterschicht (11, 12) erreicht,
wobei die zweite Halbleiterschicht (13) einen nahen Abschnitt (131) aufweist, der näher an der zweiten Stirnfläche der Halbleiterschicht (11, 12, 13) ist als der Graben (3), wobei der Graben (3) und der nahe Abschnitt (131) bei einer Betrachtung in einer Breitenrichtung (y) senkrecht zu einer Tiefenregion (x) des Grabens (3) voneinander beabstandet sind,
wobei die Halbleiterschicht (11, 12, 13) ferner eine Halbleiterregion (14) des ersten Leitfähigkeitstyps aufweist, die um den Graben (3) herum und in direktem Kontakt zu dem Graben (3) gebildet ist,
wobei ein ausgenommener Abschnitt (T2) an der zweiten Halbleiterschicht (13) vorgesehen ist,
wobei die zweite Halbleiterschicht (13) eine erste Region (131) und eine zweite Region (132) aufweist, wobei die erste Region (131) unterhalb des ausgenommenen Ausschnittes (T2) angeordnet ist und den nahen Abschnitt (131) beinhaltet, wobei die zweite Region (132) mit der ersten Region (131) in der Breitenrichtung (y) verbunden ist, wobei die erste Region (131) eine erste Bodengrenze (K2) in Kontakt mit der ersten Halbleiterschicht (11, 12) hat, wobei die zweite Region (132) eine zweite Bodengrenze (K3) in Kontakt mit der ersten Halbleiterschicht (11, 12) hat,
wobei die erste Region (131) und die zweite Region (132) die gleiche Dotierungsverunreinigung aufweisen und die gleiche Dotierungsverunreinigungskonzentration haben,
wobei der nahe Abschnitt (131) und der ausgenommene Abschnitt (T2) so angeordnet sind, dass sie einander in der Breitenrichtung (y) überlappen,
wobei der ausgenommene Abschnitt (T2) in der Breitenrichtung (y) von der Größe her kleiner ist als der nahe Abschnitt (131), und
einschließlich einer Bodenfläche, die zu dem nahen Abschnitt (131) weist, wobei die Bodenfläche von einer oberen Fläche der ersten Halbleiterschicht (11, 12) in Richtung hin zu der ersten Stirnfläche der Halbleiterschicht (11, 12, 13, 14) beabstandet ist,
wobei ein Teil der Source-Elektrode (42) in dem ausgenommenen Abschnitt (T2) angeordnet ist, und
wobei die Halbleiterschicht (11, 12, 13) ferner eine Hochkonzentrations-Halbleiterregion (13a) des zweiten Leitfähigkeitstyps beinhaltet, und zwar unter dem ausgenommenen Abschnitt (T2),
wobei eine Größe des ausgenommenen Abschnittes (T2) in der Tiefenrichtung (x) im Wesentlichen gleich einer Entfernung zwischen der ersten Bodengrenze (K2) und der zweiten Bodengrenze (K3) in der Tiefenrichtung (x) ist.

2. Halbleiterbauteil nach Anspruch 1, wobei die zweite Region (132) eine Kanalregion beinhaltet, die entlang des Grabens (3) ausgebildet ist und in Kontakt steht mit der ersten Halbleiterschicht (11, 12).

3. Halbleiterbauteil nach Anspruch 1 oder 2, wobei der ausgenommene Abschnitt (T2) eine Seitenfläche beinhaltet, die mit der Bodenfläche verbunden ist, und wobei eine Verunreinigungskonzentration an der Bodenfläche größer ist als eine Verunreinigungskonzentration an der Seitenfläche.

4. Halbleiterbauteil nach einem beliebigen der Ansprüche 1-3, wobei die Halbleiterregion (14) sich auf die Bodenfläche des ausgenommenen Abschnittes (T2) erstreckt.

5. Halbleiterbauteil nach Anspruch 3, wobei die Seitenfläche des ausgenommenen Abschnittes (T2) im Wesentlichen parallel ist zu der Tiefenrichtung (x).

6. Halbleiterbauteil nach einem beliebigen der Ansprüche 1-5, wobei die Hochkonzentrations-Halbleiterregion (13a) in der Breitenrichtung (y) zwischen dem nahen Abschnitt (131) und dem ausgenommenen Abschnitt (T2) angeordnet ist, und in direktem Kontakt mit jenem Teil der Source-Elektrode (42) gehalten ist, der in dem ausgenommenen Abschnitt (T2) angeordnet ist.

7. Halbleiterbauteil nach Anspruch 6, wobei die Hochkonzentrations-Halbleiterregion (13a) in der Breitenrichtung (y) hinsichtlich der Größe kleiner ist als die Bodenfläche des ausgenommenen Abschnittes (T2).

8. Verfahren zum Herstellen eines Halbleiterbauteils, wobei das Verfahren aufweist:
Bilden eines ausgenommenen Abschnittes (T2) auf einer Fläche eines Halbleitersubstrates (11, 12), das aus Siliziumkarbid aufgebaut ist;
Bestrahlen der gesamten Fläche des Halbleitersubstrates (11, 12) mit Ionen, wodurch eine erste Halbleiterregion (131) und eine zweite Halbleiterregion (132) eines Leitfähigkeitstyps gebildet werden, der sich von einem Halbleitertyp des Halbleitersubstrats (11, 12) unterscheidet, wobei die erste und die zweite Halbleiterregion (131, 132) miteinander verbunden sind,
wobei die erste Halbleiterregion (131) nahe an einem Bodenabschnitt des ausgenommenen Abschnittes (T2) angeordnet ist, wobei die erste Halbleiterregion (131) eine erste Bodengrenze (K2) in Kontakt mit dem Halbleitersubstrat (11, 12) aufweist, wobei die zweite Halbleiterregion (132) eine zweite Bodengrenze (K3) in Kontakt mit dem Halbleitersubstrat (11, 12) aufweist;
Bilden eines Grabens (3) in der Region, wo die zweite Halbleiterregion (132) gebildet worden ist, wobei der Graben (3) die zweite Halbleiterregion (132) durchdringt;
Bilden einer isolierenden Schicht (5) in dem Graben (3);
Bilden einer Gate-Elektrode (41), die auf die isolierende Schicht (5) in dem Graben (3) gestapelt ist; und
Bilden einer Source-Elektrode (42) auf dem Halbleitersubstrat (11, 12), und zwar auf eine Art und Weise, dass ein Teil der Source-Elektrode (42) in dem ausgenommenen Abschnitt (T2) angeordnet ist,
wobei der ausgenommene Abschnitt (T2) in einer Breitenrichtung (y) senkrecht zu einer Tiefenrichtung (x) des Grabens (3) hinsichtlich der Größe kleiner ist als die erste Halbleiterregion (131),
wobei das Verfahren ferner beinhaltet, eine Hochkonzentrations-Halbleiterregion (13a) in der ersten Halbleiterregion (131) zu bilden, wobei die Hochkonzentrations-Halbleiterregion von einem Leitfähigkeitstyp ist, der sich von dem Leitfähigkeitstyp des Halbleitersubstrats (11, 12) unterscheidet, und in direktem Kontakt mit dem Bodenabschnitt des ausgenommen Abschnittes (T2) gehalten ist, wobei die Hochkonzentrations-Halbleiterregion (13a) von dem Halbleitersubstrat (11, 12) beabstandet ist, wobei der ausgenommene Abschnitt (T2), gemessen in der Breitenrichtung (y) hinsichtlich der Größe größer ist als die Hochkonzentrations-Halbleiterregion (13a),
wobei eine Größe des ausgenommenen Abschnittes (T2) in der Tiefenrichtung (x) im Wesentlichen gleich einem Abstand zwischen der ersten Bodengrenze (K2) und der zweiten Bodengrenze (K3) in der Tiefenrichtung (x) ist.

9. Verfahren nach Anspruch 8, ferner mit dem Schritt des Bildens einer dritten Halbleiterregion (14) auf der zweiten Halbleiterregion (132), wobei die dritte Halbleiterregion (14) den gleichen Leitfähigkeitstyp hat wie das Halbleitersubstrat (11, 12).

10. Verfahren nach einem beliebigen der Ansprüche 8 oder 9, wobei der Schritt des Bildens der Gate-Elektrode (41) durchgeführt wird, nachdem die erste Halbleiterregion (131) und die zweite Halbleiterregion (132) gebildet sind.

## Revendications

1. Dispositif à semi-conducteurs comprenant :
une couche semi-conductrice (11, 12, 13) comportant une première face pourvue d'une tranchée (3) et une deuxième face opposée à la première face ;
une électrode de grille (41) prévue dans la tranchée (3) ;
une électrode de source (42) prévue sur la première face de la couche semi-conductrice (11, 12, 13) ; et
une couche isolante (5) prévue dans la tranchée (3) de manière à isoler la couche semi-conductrice (11, 12, 13) et l'électrode de grille (41) l'une de l'autre ;
dans lequel la couche semi-conductrice (11, 12, 13) comprend une première couche semi-conductrice (11, 12) d'un premier type de conductivité constituée de carbure de silicium, et une deuxième couche implantée semi-conductrice (13) d'un deuxième type de conductivité opposé au premier type de conductivité,
la tranchée (3) étant formée de manière à pénétrer à travers la deuxième couche semi-conductrice (13) et à atteindre la première couche semi-conductrice (11, 12),
dans lequel la deuxième couche semi-conductrice (13) comprend une partie proche (131) qui est plus proche de la deuxième face de la couche semi-conductrice (11, 12, 13) que ne l'est la tranchée (3), la tranchée (3) et la partie proche (131) étant espacées l'une de l'autre lorsqu'elles sont vues dans une direction de largeur (y) perpendiculaire à une direction de profondeur (x) de la tranchée (3),
dans lequel la couche semi-conductrice (11, 12, 13) comprend en outre une région semi-conductrice (14) du premier type de conductivité formée autour de la tranchée (3) et en contact direct avec celle-ci,
dans lequel une partie en retrait (T2) est prévue au niveau de la deuxième couche semi-conductrice (13),
la deuxième couche semi-conductrice (13) comprend une première région (131) et une deuxième région (132), la première région (131) étant située au-dessous de la partie en retrait (T2) et comprenant la partie proche (131), la deuxième région (132) étant reliée à la première région (131) dans la direction de largeur (y), la première région (131) ayant une première frontière inférieure (K2) en contact avec la première couche semi-conductrice (11, 12), la deuxième région (132) ayant une deuxième frontière inférieure (K3) en contact avec la première couche semi-conductrice (11, 12),
la première région (131) et la deuxième région (132) comprenant la même impureté de dopant et ayant la même concentration d'impureté de dopant,
la partie proche (131) et la partie en retrait (T2) étant disposées de manière à se superposer dans la direction de largeur (y),
la partie en retrait (T2) ayant une plus petite taille que la partie proche (131) dans la direction de largeur (y), et
comprenant une surface inférieure faisant face à la partie proche (131), la surface inférieure étant espacée d'une surface supérieure de la première couche semi-conductrice (11, 12) vers la première face de la couche semi-conductrice (11, 12, 13, 14),
dans lequel une partie de l'électrode de source (42) est disposée dans la partie en retrait (T2), et
dans lequel la couche semi-conductrice (11, 12, 13) comprend en outre une région semi-conductrice à forte concentration (13a) du deuxième type de conductivité sous la partie en retrait (T2),
dans lequel une taille de la partie en retrait (T2) dans la direction de profondeur (x) est sensiblement égale à une distance entre la première frontière inférieure (K2) et la deuxième frontière inférieure (K3) dans la direction de profondeur (x).

2. Dispositif à semi-conducteurs selon la revendication 1, dans lequel la deuxième région (132) comprend une région de canal formée le long de la tranchée (3) et en contact avec la première couche semi-conductrice (11, 12).

3. Dispositif à semi-conducteurs selon la revendication 1 ou 2, dans lequel la partie en retrait (T2) comprend une surface latérale reliée à la surface inférieure, et une concentration d'impureté au niveau de la surface inférieure est supérieure à une concentration d'impureté au niveau de la surface latérale.

4. Dispositif à semi-conducteurs selon l'une quelconque des revendications 1 à 3, dans lequel la région semi-conductrice (14) s'étend sur la surface inférieure de la partie en retrait (T2).

5. Dispositif à semi-conducteurs selon la revendication 3, dans lequel la surface latérale de la partie en retrait (T2) est sensiblement parallèle à la direction de profondeur (x).

6. Dispositif à semi-conducteurs selon l'une quelconque des revendications 1 à 5, dans lequel la région semi-conductrice à forte concentration (13a) est disposée entre la partie proche (131) et la partie en retrait (T2) dans la direction de largeur (y), et est maintenue en contact direct avec ladite partie de l'électrode de source (42) disposée dans la partie en retrait (T2).

7. Dispositif à semi-conducteurs selon la revendication 6, dans lequel la région semi-conductrice à forte concentration (13a) a une plus petite taille que la surface inférieure de la partie en retrait (T2) dans la direction de largeur (y).

8. Procédé de fabrication d'un dispositif à semi-conducteurs, le procédé comprenant :
la formation d'une partie en retrait (T2) sur une surface d'un substrat semi-conducteur (11, 12) constitué de carbure de silicium ;
l'irradiation de la surface entière du substrat semi-conducteur (11, 12) avec des ions, formant de ce fait une première région semi-conductrice (131) et une deuxième région semi-conductrice (132) d'un type de conductivité différent d'un type de conductivité du substrat semi-conducteur (11, 12), les première et deuxième régions semi-conductrices (131, 132) étant reliées l'une à l'autre,
la première région semi-conductrice (131) étant située à proximité d'une partie inférieure de la partie en retrait (T2), la première région semi-conductrice (131) ayant une première frontière inférieure (K2) en contact avec le substrat semi-conducteur (11, 12), la deuxième région semi-conductrice (132) ayant une deuxième frontière inférieure (K3) en contact avec le substrat semi-conducteur (11, 12) ;
la formation d'une tranchée (3) dans la région où la deuxième région semi-conductrice (132) a été formée, la tranchée (3) pénétrant à travers la deuxième région semi-conductrice (132) ;
la formation d'une couche isolante (5) dans la tranchée (3) ;
la formation d'une électrode de grille (41) empilée sur la couche isolante (5) dans la tranchée (3) ; et
la formation d'une électrode de source (42) sur le substrat semi-conducteur (11, 12) de manière à ce qu'une partie de l'électrode de source (42) soit disposée dans la partie en retrait (T2),
dans lequel la partie en retrait (T2) a une plus petite taille que la première région semi-conductrice (131) dans une direction de largeur (y) perpendiculaire à une direction de profondeur (x) de la tranchée (3),
le procédé comprenant en outre la formation d'une région semi-conductrice à forte concentration (13a) dans la première région semi-conductrice (131), dans lequel la région semi-conductrice à forte concentration a un type de conductivité différent du type de conductivité du substrat semi-conducteur (11, 12) et est maintenue en contact direct avec la partie inférieure de la partie en retrait (T2), la région semi-conductrice à forte concentration (13a) étant espacée du substrat semi-conducteur (11, 12), la partie en retrait (T2) ayant une plus grande taille lorsqu'elle est mesurée dans la direction de largeur (y) que la région semi-conductrice à forte concentration (13a),
dans lequel une taille de la partie en retrait (T2) dans la direction de profondeur (x) est sensiblement égale à une distance entre la première frontière inférieure (K2) et la deuxième frontière inférieure (K3) dans la direction de profondeur (x).

9. Procédé selon la revendication 8, comprenant en outre la formation d'une troisième région semi-conductrice (14) sur la deuxième région semi-conductrice (132), la troisième région semi-conductrice (14) ayant le même type de conductivité que le substrat semi-conducteur (11, 12).

10. Procédé selon l'une quelconque des revendications 8 ou 9, dans lequel l'étape de formation de l'électrode de grille (41) est effectuée après que la première région semi-conductrice (131) et la deuxième région semi-conductrice (132) ont été formées.
